(19) Europäisches Patentamt
European Patent Office
Office européen des brevets

(11) EP 1 811 059 B1

(12) **EUROPEAN PATENT SPECIFICATION**

(45) Date of publication and mention of the grant of the patent:
**31.10.2012 Bulletin 2012/44**

(21) Application number: **05787960.3**

(22) Date of filing: **27.09.2005**

(51) Int Cl.:
***C23C 16/18*** *(2006.01)* ***H01L 21/3205*** *(2006.01)*
***H01L 21/285*** *(2006.01)* ***C07F 7/18*** *(2006.01)*

(86) International application number:
**PCT/JP2005/017772**

(87) International publication number:
**WO 2006/035784 (06.04.2006 Gazette 2006/14)**

(54) **PROCESS FOR FORMATION OF COPPER-CONTAINING FILM**

VERFAHREN ZUR AUSBILDUNG EINES KUPFERHALTIGEN FILMS

PROCÉDÉ DE FORMATION DE FILM CONTENANT DU CUIVRE

(84) Designated Contracting States:
**AT BE BG CH CY CZ DE DK EE ES FI FR GB GR HU IE IS IT LI LT LU LV MC NL PL PT RO SE SI SK TR**

(30) Priority: **27.09.2004 JP 2004279366**

(43) Date of publication of application:
**25.07.2007 Bulletin 2007/30**

(73) Proprietors:
- **ULVAC, INC.**
  **Chigasaki-shi, Kanagawa 253-8543 (JP)**
- **Ube Industries, Ltd.**
  **Ube-shi, Yamaguchi-ken 755-8633 (JP)**

(72) Inventors:
- **WATANABE, Mikio,**
  **c/o ULVAC, Inc.,**
  **Susono-shi, Shizuoka 4101231 (JP)**
- **ZAMA, Hideaki,**
  **c/o ULVAC, Inc.,**
  **Susono-shi,**
  **Shizuoka 4101231 (JP)**
- **KADOTA, Takumi,**
  **c/o UBE INDUSTRIES, LTD.,**
  **Ube-shi, Yamaguchi 7558633 (JP)**
- **HASEGAWA, Chihiro,**
  **c/o UBE INDUSTRIES, LTD.,**
  **Ube-shi, Yamaguchi 7558633 (JP)**
- **WATANUKI, Kouhei,**
  **c/o UBE INDUSTRIES, LTD.,**
  **Ube-shi, Yamaguchi 7558633 (JP)**

(74) Representative: **AMMANN PATENTANWÄLTE AG BERN**
**Schwarztorstrasse 31**
**Postfach 5135**
**3001 Bern (CH)**

(56) References cited:
**WO-A-2004/007792 JP-A- 2003 017 437**
**JP-A- 2003 292 495 JP-A- 2003 292 495**
**US-A- 6 077 571 US-A1- 2004 009 665**

- **KOBAYASHI AKIKO ET AL: "Gap-filling property of Cu film by chemical vapor deposition", JOURNAL OF VACUUM SCIENCE & TECHNOLOGY B: MICROELECTRONICSPROCESSING AND PHENOMENA, AMERICAN VACUUM SOCIETY, NEW YORK, NY, US, vol. 17, no. 5, 1 September 1999 (1999-09-01), pages 2256-2261, XP012007726, ISSN: 0734-211X, DOI: DOI: 10.1116/1.590902**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 811 059 B1

## Description

### Technical Field

The present invention relates to a method for forming a copper-containing film and, in particular, to a method for forming a copper-containing film, which comprises the step of forming a copper-containing film, by the CVD technique, on a primary coat consisting of a vanadium film formed according to the CVD technique.

### Background Art

With respect to the electrical connections or distributing wires required when fabricating a semiconductor device (such as an LSI or IC device or the like), it is common that a barrier layer and/or an adherent layer are formed, as a primary coat, in or on contact holes and grooves which permit the connection between lower and upper distributing wires. This barrier layer has frequently been formed, between layers of a connection material or a wire material and an insulating material, for the purpose of preventing any mutual diffusion between the wire material and the insulating material and hence preventing the occurrence of any deterioration of the characteristic properties of such a semiconductor device, while the adherent later has likewise frequently been formed, between layers of a wire material and an insulating material, for the purpose of preventing any peeling of films at the boundary between the layers of the wire material and the insulating material.

There has recently been proposed the use of a copper material having a lower specific resistance (resistivity) as a material for forming distributing wires within contact holes and/or grooves, in place of the conventionally used Al materials. In this case, a barrier layer is formed between copper distributing wires and a silicon oxide film or the like, in order to prevent any diffusion of copper into an insulating layer consisting of, for instance, a silicon oxide film serving as a primary coat for the copper distributing wires.

Incidentally, there has conventionally been used the plating technique in the formation of such copper distributing wires described above. However, the size of contact holes or the like has been longer and narrower as the reduction of the scale of the distributing wires of, for instance, LSI devices, and an additional problem arises, such that it would be difficult for a plating solution to penetrate into even the deep depth or interior of, for instance, such long and narrow contact holes having such a high aspect ratio. Accordingly, this makes the formation of copper distributing wires from such a plating solution, quite difficult.

For this reason, under the existing circumstances, there has been investigated, as a means for forming copper distributing wires, a method represented by the CVD technique, which makes use of a gas, as a substitute for the plating technique.

When it is intended to form a copper-containing film according to the CVD technique, a variety of problems arise, such that the raw material undergoes some changes with the elapse of time; that the copper-containing film thus formed never has stable desired characteristic properties; and that a vaporizer or the like is quite liable to cause clogging during the film-forming procedures and therefore, such a method has not yet been put into practical use, at present. In particular, in the copper-containing film-forming process, it would be a serious problem that the method cannot stably provide films each having a low resistance.

When using a copper film formed according to the CVD technique as distributing wires, there has been known a method which comprises the steps of forming, in advance, a vanadium nitride film according to the reactive sputtering technique or the CVD technique and then growing a film of a copper material on the vanadium nitride film by the CVD technique to thus form a barrier layer having good adhesion to the copper film and having a small internal stress (see, for instance, Patent Document 1 specified later). In this case, bis(cyclopenta-dienyl) vanadium(III) is, for instance, used as a raw material for forming a barrier layer, but any satisfactory barrier layer has not always been formed. Moreover, there has been used known materials such as hexafluoro-acetyl acetonato copper(I) trimethyl vinyl silane [Cu(hfac)(tmvs)] as the raw materials for forming copper-containing films, but the hole is not always completely filled therewith when the diameter of the hole is small, under the existing circumstances.

Moreover, the conventionally used Cu(hfac)(tmvs) described above likewise suffers from additional problems such that a vaporizer undergoes clogging during the film-forming procedures; that raw materials cause separation or deposition within raw material-accommodating containers; and that any desired copper-containing film cannot be formed in good reproducibility.

When forming copper distributing wires for, for instance, an LSI device, the foregoing problems would arise and accordingly, the conventional techniques would never permit the formation of any highly reliable distributing wire. Thus, one of the causes for this would be believed to be the instability of the raw materials typical of the Cu(hfac)(tmvs) complex described above and for this reason, there has been desired for the development of a raw material for forming copper-containing film, which would have satisfactory characteristic properties.

Moreover, there have likewise been known special copper complexes as raw materials for forming copper-containing films according to the CVD technique (see, for instance, Patent Document 2 specified below). When using such a copper complex, however, there are many problems remaining unsolved. For instance, any condition required for forming a desired copper-containing film has not yet been elucidated.

Patent Document 1: Japanese Un-Examined Patent Publication 2003-17437 (Claims);
Patent Document 2: Japanese Un-Examined Patent Publication 2003-292495 (Claims).

Disclosure of the Invention

Problems That the Invention is to Solve

Accordingly, it is an object of the present invention to solve the foregoing problems associated with the conventional techniques and more specifically, to provide a method for forming a copper-containing film having excellent characteristic properties, which comprises the step of forming a copper-containing film according to the CVD technique, while using a specific copper complex as a raw material for forming such a copper-containing film and, more specifically, to provide a method for forming a copper-containing film, which can solve the problem concerning the instability of the raw materials and the instability of or the low reproducibility in the copper-containing film formation and which can provide a film having a low resistance and improve the uniformity of the resulting film throughout the surface of a substrate.

**Means for the Solution of the Problems**

The inventors of the present invention have conducted various investigations to form a copper-containing film having a low resistance at a low temperature on the basis of such an idea that one of the reason for causing the foregoing problems associated with the conventional techniques may be as follows: the monovalent copper material represented by the foregoing Cu(hfac)(tmvs) complex is unstable. For this reason, the inventors have investigated a variety of more stable divalent copper materials. As a result, the inventors have found that the use of copper complexes such as those described below in detail, among divalent copper- containing raw materials, would permit the solution of the problems concerning the instability of the raw materials and the instability of the copper-containing film formation, likewise permit the formation of a film having a reduced resistance and ensure the uniform distribution thereof on the substrate surface and have thus completed the present invention.

Accordingly, the present invention herein provides a method for forming a copper-containing film on the surface of a subject on which the film is to be formed, according to the CVD technique, using a copper complex represented by the following general formula (I) (in formula (I), X, Y and Z are the same as those specified below) which possesses, as a ligand, a β-diketonate group represented by the following general formula (I)' (in the formula (I)', Z represents a hydrogen atom or an alkyl group having 1 to 4 carbon atoms; X represents a group denoted by the following general formula (I-I) (in the formula (I-I), $R^a$ represents a linear or branched alkylene group having 1, to 5 carbon atoms, and $R^b$, $R^c$ and $R^d$ each independently represent a linear or branched alkyl group having 1 to 5 carbon atoms), Y represents a group denoted by the following general formula (I-I) (in the formula (I-I), $R^a$ represents a linear or branched alkylene group having 1 to 5 carbon atoms, and $R^b$, $R^c$ and $R^d$ each independently represent a linear or branched alkyl group having 1 to 5 carbon atoms) or a linear or branched alkyl group having 1 to 8 carbon atoms):

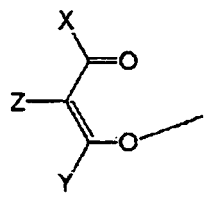

(I)'

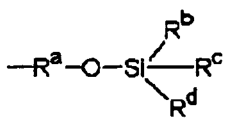

(I - I)

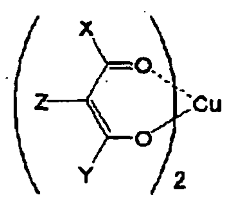

(I)

and a hydrogen atom-containing gas, wherein the copper-containing film is formed while supplying the copper complex gas and the hydrogen atom-containing gas in such a manner that the following relationship is satisfied between the ratio of the feed of the hydrogen atom-containing gas to that of the copper complex gas and the partial pressure of the hydrogen atom-containing gas:

$$\{(\text{Feed (cc/min) of the hydrogen atom-containing gas})/(\text{feed (cc/min) of the copper complex gas})\} \times (\text{partial pressure (Pa) of the hydrogen atom-containing gas}) \geqq 50{,}000$$

In the present invention, if the foregoing relation is not satisfied, it would be impossible to form a copper-containing film having a low resistance at a low temperature. In this respect, there is not any particular upper limit in the this relation and any desired purpose of the present invention can be accomplished insofar as the foregoing relation is less than $3 \times 10^9$ which corresponds to the technical limit of the CVD process. Such a hydrogen atom- containing gas may be a member selected from the group consisting of $NH_3$, $H_2$, $SiH_4$, $Si_2H_6$ and hydrazine derivatives (those each obtained by replacing one or two hydrogen atoms of a hydrazine molecule with methyl, ethyl, or linear or branched butyl groups, which may be the same or different). Particularly preferably used herein is $H_2$ gas, among others.

The film-forming temperature for the formation of the foregoing copper-containing film preferably ranges from 150 to 350°C. If the film-forming temperature is less than 150°C, it takes a long period of time for the formation of a desired quantity of films and accordingly, the use of such a low temperature is impractical. On the other hand, the use of a film-forming temperature of higher than 350°C is not preferred, since the resulting film has a high specific resistance.

Prior to the formation of the foregoing copper-containing film, it is preferred to form a primary layer consisting of a vanadium-containing film using a tetravalent amide type vanadium-containing organometallic raw gas and a reducing gas according to the CVD technique.

The foregoing tetravalent amide type vanadium-containing organometallic raw materials may preferably be, for instance, tetrakis-diethylamino vanadium (hereunder referred to as "TDEAV"), tetrakis-dimethylamino vanadium (hereunder referred to as "TDMAV") or tetrakis-ethylmethylamino vanadium.

The foregoing reducing gas is preferably one capable of releasing $H^*$ radicals or $H^+$ ions through dissociation.

The foregoing reducing gas is preferably a member selected from the group consisting of hydrazine derivatives, $NH_3$, $H_2$, $SiH_4$ and $Si_2R_6$. The hydrazine derivatives are preferably those each obtained by replacing one or two hydrogen atoms of a hydrazine molecule with methyl, ethyl, or linear or branched butyl groups. These substituents may be the same or different. In addition, the hydrazine derivative is more preferably a tert-butyl hydrazine.

The reaction of the foregoing tetravalent amide type vanadium-containing organometallic raw material gas with a reducing gas is preferably carried out at a temperature falling within the range in which the film-forming rate is dependent on the temperature of the subject on which the film is to be formed, to thus form a vanadium- containing film.

## Effects of the Invention

According to the present invention, a copper-containing film is formed using a copper-containing complex represented by the foregoing general formula (I) according to the CVD technique and this would permit the stable formation of such a copper-containing film having a low specific resistance at a low temperature. Contrary to this, the conventional method for forming a copper-containing film using a monovalent copper-containing raw material suffers from various problems such that a vaporizer undergoes clogging during the film-forming procedures; that raw materials cause separation or deposition within raw material-accommodating containers; and that any desired copper-containing film cannot be formed in good reproducibility. However, the copper complex raw material used in the present invention shows a variety of excellent effect such that it never causes any clogging of the unit for evaporating the same and therefore, the use thereof would considerably improve the availability factor of the copper-containing film-forming apparatus. More specifically, when operating the film-forming apparatus over one year, there are not confirmed any quality change of raw materials as well as any clogging of pipe arrangement, valves, a vaporizer and a shower plate at all.

## Best Mode for Carrying Out the Invention

First, the structure of an embodiment of a CVD apparatus used for practicing the copper-containing film-forming method according to the present invention will be described below in detail with reference to the accompanying drawings. The CVD apparatus can likewise be used for forming a layer such as a barrier layer serving as a primary coat for electrical connections or distributing wires consisting of a copper-containing film and therefore, the apparatus will be described below while taking into consideration the both of the step of forming the copper-containing film and the step of forming the barrier layer.

The CVD apparatus as shown in Fig. 1 is composed of a gas-supply unit 1 for supplying, to the CVD apparatus, a carrier gas (such as $N_2$, Ar or He) and a reducing gas (such as $NH_3$ or $H_2$); a raw material-supply unit 2 for supplying film-forming materials; a reaction unit 3 for forming a metal-containing film; and an exhaust system 4 for discharging the raw material and the gases.

The gas-supply unit 1 has such a function that it can transport the carrier gas and the reducing gas from the gas sources of these respective gases to the reaction unit 3 through pipe arrangement and mass flow-controllers (such

as MFC1 or MFC2 shown in the accompanying drawings), while controlling the flow rate of each gas.

The raw material-supply unit 2 has such a function that it can transport the raw material 202 included in a container 201 thereof to a reaction chamber 301 of the reaction unit 3, while controlling the flow rate and pressure of the raw material to be supplied to the chamber. Referring now to Fig. 1, this raw material-supply unit can be used for supplying a raw material which is in a liquid or solid state at ordinary temperature and accordingly, the unit is used for converting, into a gas, a copper-containing film-forming raw material; a vanadium-containing film-forming organometallic raw material such as TDEAV or TDMAV; a reducing gas material, for instance, a hydrazine derivative (such as tertiary butyl hydrazine (TBH)) through a vaporizer 203 and introducing the gas thus obtained into the reaction unit 3. One of the basic structures of the raw material-supply unit as shown in Fig. 1 is so designed that the gas such as the gaseous raw material can be transported to the reaction chamber 301 while controlling the flow rate and/or the pressure thereof supplied through the mass flow-controllers (such as L-MFC and MFC3 as shown in Fig. 1) and a pressure gage (such as those specified by the reference numerals 204 and 205 in Fig. 1). The pipe arrangement or piping work for transporting a raw material starting from the container 201 for accommodating a raw material to a shower plate 302 of the reaction unit 3 and respective component parts such as valves are all subjected to a desired temperature- controlling treatment. In this respect, the temperature thereof is preferably controlled in such a manner that it falls within the range of from room temperature to about 270°C. Thus, the temperature of these parts can be controlled so that the gaseous raw material is never converted into a liquid to thus undergo any separation or deposition within them.

The reaction unit 3 is composed of a shower plate 302 for appropriately supplying, to the surface of a substrate S, gaseous materials such as a gaseous raw material, a reducing gas and a carrier gas supplied from the raw material-supply unit 2, and a carrier gas, a reducing gas and the like supplied from the gas-supply unit 1; a reaction chamber 301 for holding a desired film-forming atmosphere in the proximity of the substrate S; a substrate-placing table 303 capable of being heated (this is equipped with a heating means, although any such means is not shown in the figure); a gate valve 304 for isolating the atmosphere within the reaction chamber from, for instance, the neighboring substrate-transporting chamber; and a pressure gage 305 for monitoring the pressure of the film-forming atmosphere within the reaction chamber. The shower plate 302 is prepared from, for instance, a metal (such as stainless steel, Al, an Al alloy, Hastelloy (registered trade mark), or Inconel (available from INCO Company, Canada)) and the shower plate is preferably so designed that the temperature thereof can be controlled to a level ranging from room temperature to 250°C. The reaction chamber 301 is prepared from a metal (such as stainless steel, Al, an Al alloy, Hastelloy or Inconel) and the reaction chamber is preferably so designed that the temperature thereof can likewise be adjusted to a level ranging from room temperature to 250°C. The substrate-placing table 303 can be prepared using a metal (such as stainless steel, Al, an Al alloy, Hastelloy or Inconel) or a ceramic material (such as $Al_2O_3$, AlN, SiN, SiC, or $SiO_2$) Preferably used herein is a substrate-placing table made of a ceramic material and the table is preferably prepared using AlN, among others, since it has a high thermal conductivity and it also shows a good temperature distribution even at a high temperature. The substrate-placing table 303 made of AlN can withstand the heat treatment carried out at a temperature ranging from room temperature to 600°C. The gate valve 304 is prepared using, for instance, a metal (such as stainless steel, Al, an Al alloy, Hastelloy or Inconel), and it is equipped with temperature monitors and heating means such as heaters in the interior and/or on the exterior of the same so that the temperature thereof can be controlled to a level ranging from room temperature to 250°C. The pressure gage 305 used herein should be one capable of withstanding a high temperature.

The exhaust system 4 is a unit for adjusting the atmosphere within the reaction chamber 301. As shown in Fig. 1, the basic structure thereof comprises pipe arrangement, an exhaust valve 401, a pressure-control valve 402, a trap 403 for raw materials and a vacuum pump 404. The temperature of the respective parts distributed or arranged between the reaction chamber 301 and the vacuum pump 404 are all controlled to a desired level preferably ranging from room temperature to 250°C. The pressure-control valve 402 can be opened or closed so that the pressure within the chamber may be set at an arbitrary level in response to the operation of the pressure gage 305 arranged in the reaction chamber 301, on the basis of the set value thereof. In addition, the pipe arrangement 5 is provided for directly transporting the gaseous raw material leaving the raw material-supply unit 2 to the trap 403 for raw materials of the exhaust system 4 and accordingly, the gaseous raw material can stably be supplied to the reaction chamber 301 by switching the passage for transporting the raw gas toward the side of the reaction chamber 301 at an instance when the flow rate or supplied amount of the gaseous raw material discharged from the raw material-supply unit 2 is stabilized. Moreover, when the supply of the gaseous raw material is interrupted or when the desired film-forming reaction is completed, the supply of the gaseous raw material to the reaction chamber 301 can immediately be terminated by switching the passage for transporting the raw gas toward the side of the pipe arrangement 5 to thus guide the gaseous raw material to the trap 403. This trap 403 for raw materials is a unit having such a function that it can recover the gaseous raw material discharged from, for instance, the reaction chamber and it is quite effective for reducing the load (any clogging within the pump) applied to the vacuum pump 404 and for the reuse of the gaseous raw material. To improve the exhaustion power of the vacuum pump 404 as shown in Fig. 1, a secondary vacuum pump may be positioned between the pressure-control valve 402 and the vacuum pump 404.

The foregoing raw material-supply unit usable in the present invention may likewise have a structure such as

those shown in Figs. 2 to 4 in addition to that depicted in Fig. 1. Either of these structures including that as shown in Fig. 1 is so designed that the gaseous raw material can be transported to the reaction chamber 301 while controlling the flow rate and/or pressure thereof supplied through the mass flow-controllers (such as L-MFC, MFC3 and MFC4 as shown in Figs. 2 to 4) and pressure gages (such as those specified by the reference numerals 204 and 205 as shown in Figs. 2 to 4). In this connection, any vaporizer is not shown in the accompanying figures, but the unit may, if necessary, be provided with a vaporizer.

The raw material-supply unit 2 as shown in Fig. 2 has such a structure that the gaseous raw material 202 contained in the container 201 for accommodating the raw material can be transported to the reaction chamber 301 through a mass flow controller (L-MFC) by the action of a pressurized gas (such as $N_2$, Ar or He) supplied at a predetermined pressure. Similarly, the raw material-supply unit 2 as shown in Fig. 3 has such a structure that the gaseous raw material 202 contained in the container 201 for accommodating the raw material can be transported to the reaction chamber 301 through a mass flow controller (MFC3) simultaneous with a carrier gas and a reducing gas supplied at desired pressures. In addition, the raw material-supply unit 2 as shown in Fig. 4 has such a structure that the gaseous raw material 202 contained in the container 201 for accommodating the raw material can be transported to the reaction chamber 301 through a mass flow controller, (MFC4).

In the present invention, a barrier layer and/or an adherent layer are formed on the surface of a substrate prior to the formation of an intended copper-containing film and in this connection, metallic raw materials capable of being used in the formation of such barrier and/or adherent layers are preferably tetravalent amide type vanadium-containing organometallic raw materials and specific examples thereof include $V[NR^1R^2]_4$, $V[NR^1R^2]_3 \cdot Cl$, $V[NR^1R^2]_2 \cdot Cl_2$ and $V[NR^1R^2] \cdot Cl_3$; , wherein $R^1$ and $R^2$ may be the same or different from one another and each represent a member selected from the group consisting of, for instance, $C_nH_{2n+1}$ (n is an integer ranging from 0 to 4), $C_mH_{2m}O$ (m is an integer ranging from 0 to 4), $CH_2OH$ and phenyl groups. Cl may be replaced with a halogen atom other than Cl. More preferably used herein are TDEAV and TDMAV, listed above, among the foregoing metallic raw materials.

The foregoing reducing gases usable herein include, for instance, those capable of generating H* radicals or $H^+$ ions through decomposition or dissociation and examples thereof are hydrazine derivatives (such as tertiary butyl hydrazine (TBH): $(CH_3)_3CNHNH_2$), $NH_3$, $H_2$ and $SiH_4$. It is also possible to use other hydrazine derivatives (such as those formed by replacing one or two hydrogen atoms of a hydrazine molecule with a substituent selected from the group consisting of groups such as methyl, ethyl and linear or branched butyl groups). Among these reducing gases, preferably used herein are gases (such as TBH and $NH_3$) which can react with a gas such as TDEAV and can accelerate the nitrification in the step for forming a vanadium-containing film or a titanium-containing film.

As the carrier gases, usable herein are, for instance, rare gases such as argon and helium; and inert gases such as $N_2$.

Next, an example of the copper complex usable in the present invention will hereunder be described in more detail.

Specific examples of silyl ether-containing β-diketone compounds which are used as ligands of this copper complex and which can provide copper β -diketonate complexes may be, for instance, those represented by the following structural formulas (III)' to (XIV)':

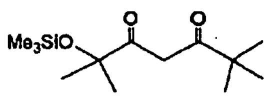

(III)'

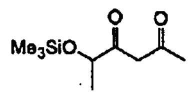

(IV)'

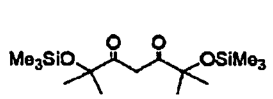

(V)'

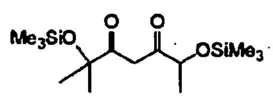

(VI)'

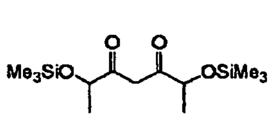

(VII)'

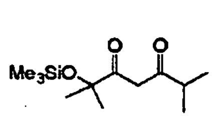

(VIII)'

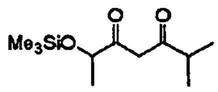

(IX)'

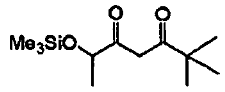

(X)'

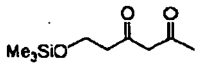

(XI)'

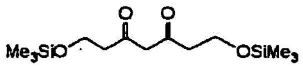

(XII)'

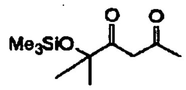

(XIII)'

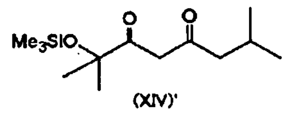

(XIV)'

These β-diketone compounds can be prepared according to any known method (such as that disclosed in Japanese Un-Examined Patent Publication 2003-292495).

The copper β-diketonate complex or a copper complex having enolate anions of β-diketone as ligands thereof can be prepared by, for instance, the reaction of the foregoing β-diketone with copper hydroxide (copper complex synthesis method 1 specified below). A solvent is used in the synthesis and usable herein include almost all of the organic solvents, for instance, hydrocarbons such as hexane and toluene; ethers such as THF and dimethoxy ethane; nitriles such as acetonitrile; halogenated hydrocarbons such as dichloromethane; alcohols such as isopropanol; and esters such as ethyl acetate. The water generated through the reaction in the synthesis method 1 may be removed from the reaction system by, for instance, a method which makes use of the azeotropic distillation thereof together with the reaction solvent such as toluene; a method in which the water is removed from the reaction system through the evaporation at room temperature under a reduced pressure together with the reaction solvent such as THF after the completion of the reaction; or by a method in which the reaction is carried out in the co-existence of a dehydrating agent such as anhydrous sodium sulfate, anhydrous magnesium sulfate, anhydrous copper sulfate, molecular sieves, or a water-absorptive polymer (such as nonionic type ones) to thus remove the water generated during the reaction, through the dehydration action of the dehydrating agent.

Complex Synthesis Method 1:

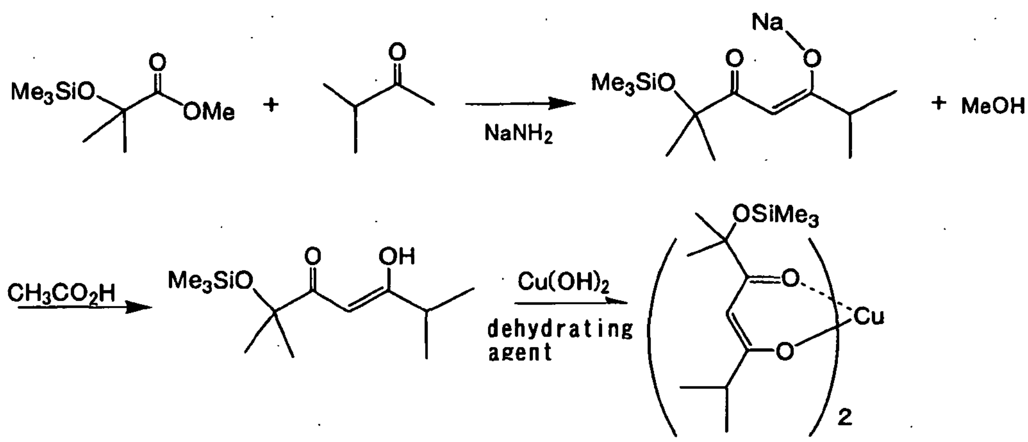


(VIII)

The compound represented by the following structural formula (VIII) is an example of the foregoing copper complex having silyl ether type β-diketonate ligands. This complex corresponds to the copper complex whose ligands are those derived from the compounds represented by the foregoing structural formula (VIII)', or the copper complex

represented by the foregoing general formula (I) wherein X is a group: $(CH_3)_3SiO-C(CH_3)_2-$; Y is a group: $(CH_3)_2CH-$; and Z is H, or more specifically, a copper complex having enolate anions of β-diketone as ligands thereof: bis(2,6-dimethyl-2-(trimethyl-silyloxy)-3,5-heptanedionato) copper(II) complex: $C_{24}H_{46}CuO_6Si_2$ (hereunder referred to as Cu $(SOPD)_2$ or SOPD):

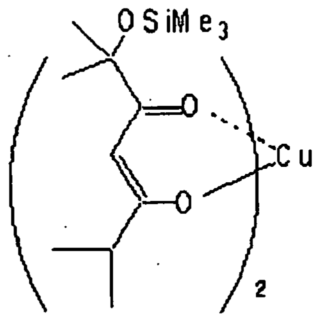

(VIII)

Each of the β-diketones represented by the foregoing structural formulas (III)' to (VII)' and the foregoing structural formulas (IX)' to (XIV)' may likewise provide each corresponding copper complex having enolate anions derived from each β-diketone as ligands thereof and having a structure similar to that represented by the foregoing structural formula (VIII).

In addition, it is also possible to prepare, according to the foregoing method, bis(2-methyl-2-(trimethyl-silyloxy)-3,5-heptanedionato)copper(II)complex:$C_{22}H_{42}Cu\ O_6Si_2$ (hereunder referred to as $Cu(SOED)_2$) represented by the following formula (XV):

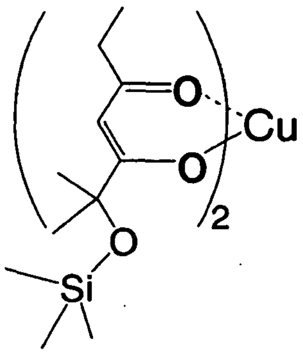

(XV)

For instance, the β-diketone serving as a starting material for the ligand of this copper complex or the β-diketonate ligand is a compound capable of being easily synthesized according to the known method as will be described below and this copper complex can likewise be prepared by the method described below.

Preparation Example 1: Synthesis of Methyl 2-Trimethylsilyloxy Isobutyrate:

To a 1L inner volume flask equipped with a stirring machine, a thermometer and a dropping funnel, there were added 54.0g (457mM) of methyl 2-hydroxy isobutyrate, 86.0g (464mM) of tri-n-butylamine and 300 ml of methyl cyclohexane after replacing the internal atmosphere of the flask or the reaction system with argon gas. Then 49.5g (456mM) of chloro-trimethylsilane was gently dropwise added to the contents of the flask, while maintaining the temperature thereof at 15°C and subsequently, the contents of the flask were reacted with one another at that temperature for one hour, with stirring. After the completion of the reaction, 120 ml of water was added to the reaction liquid while ice-cooling the same. The resulting organic phase was separated from the reaction liquid, followed by the washing of the same with water, and the subsequent drying of the organic phase over anhydrous sodium sulfate. After the filtration of the organic phase, the resulting filtrate was concentrated, the resulting concentrate was then distilled under reduced pressure (74°C, 5.32kPa) to thus give 61.0g (isolation yield: 70%) of methyl 2-trimethylsilyloxy isobutyrate as a colorless liquid.

Physical properties of the methyl 2-trimethylsilyloxy isobutyrate thus prepared were found to be as follows:

$^1$H-NMR ($CDCl_3$, δ (ppm)): 0.08 (9H, s), 1.40 (6H, s), 3.67 (3H, s)
MS (m/e): 175, 131, 99, 73

Preparation Example 2: Synthesis of 2-Methyl-2-Trimethylsylyloxy-3,5-Heptanedione

To a 200 ml inner volume flask equipped with a stirring machine, a thermometer and a dropping funnel, there were added 11.2g (99.8mM) of potassium t-butoxide and 40 ml of tetrahydrofuran after replacing the internal atmosphere of the flask or the reaction system with argon gas. Then 7.20g (99.8mM) of 2-butanone was gently dropwise added to the contents of the flask, while water-cooling the same, followed by the stirring thereof for 10 minutes, the dropwise addition of 9.70g (51.0mM) of methyl 2-trimethylsylyloxy isobutyrate prepared according to the same method used in Preparation Example 1 and the subsequent reaction of these ingredients at 5°C for one hour with stirring. After the completion of the reaction, to the reaction system, there were added 8g (133mM) of acetic acid and 16 ml of water while ice-cooling the same. The resulting organic phase was separated from the reaction system, followed by the washing of the same with water, and the subsequent drying of the organic phase over anhydrous sodium sulfate. After the filtration of the organic phase, the resulting filtrate was concentrated and the resulting concentrate was then distilled under reduced pressure (118°C, 2.66kPa) to thus give 4.46g (isolation yield: 38%) of 2-methyl-2-trimethylsilyloxy-3,5-heptanedione as a colorless liquid.

The 2-methyl-2-trimethylsilyloxy-3,5-heptanedione thus prepared was inspected for various physical properties and they were found to be as follows:

$^1$H-NMR ($CDCl_3$, δ (ppm)): 0.12 (2.61H, s), 0.13 (6.39H, s), 1.03 (0.87H, t), 1.12 (2.13H, t), 1.32 (1.74H, s), 1.37 (4.26H, s), 2.32 (0.58H, q), 2.49 (1.42H, q), 3.68 (0.58H, s), 5.94 (0.71H, s), 15.4 (0.71H, s)
IR (neat ($cm^{-1}$)): 2980, 1607(br), 1460, 1377, 1359, 1253, 1197, 1114, 1045, 915, 842, 755 (in this respect, the peak appearing at 1607$cm^{-1}$ is one peculiar to β -diketone).
MS (m/e): 215, 131, 73, 29

Preparation Example 3: Synthesis of Bis(2-Methyl-2-Trimethylsylyloxy-3,5-Heptanedionate) Copper(II) ($Cu(SOED)_2$):

To a 500 ml inner volume flask equipped with a stirring machine, a thermometer and a dropping funnel, there were added 35.63g (154.7mM) of 2-methyl-2-trimethylsilyloxy-3,5-heptanedione prepared according to the same method used in Preparation Example 2 and 100ml of methyl cyclohexane and then a solution of copper acetate monohydrate (16.1g, 80.8mM) in 240ml of water was gently dropwise added to the contents of the flask and these components were reacted with one another at room temperature for one hour with stirring. After the completion of the reaction, the resulting organic phase was separated from the reaction system, followed by the concentration of the organic phase, and the subsequent distillation of the resulting concentrate under reduced pressure (165°C, 27Pa) to thus give 34,2g (isolation yield: 81%) of bis(2-methyl-2-trimethylsylyloxy-3,5-heptanedionate) copper(II) as a dark green solid material.

The bis(2-methyl-2-trimethylsylyloxy-3,5-heptane-dionate) copper(II) thus prepared were inspected for various physical properties and they were found to be as follows:

Melting point: 53°C;
IR (neat ($cm^{-1}$)): 3500(br), 1567, 1522, 1507, 1431, 1414, 1375, 1249, 1203, 1187, 1147, 1051, 920, 861, 838, 751, 633, 534 (the peak peculiar to β-diketone (1607$cm^{-1}$) is disappeared, while the peak (1567$cm^{-1}$) peculiar to β-diketonate is observed).
Elemental Analysis (for $C_{22}H_{42}O_6Si_2Cu$): C: 50.9%, H: 8.13%, Cu: 12.2% (Found);
C: 50.6%, H: 8.11%, Cu: 12.2% (Calculated)
MS (m/e): 514, 423, 391, 375, 259, 215, 131, 73

As methods for vaporizing the foregoing copper complex used when forming a copper-containing film according to the CVD technique (the ordinary pressure- or reduced pressure-CVD technique), there may be used, for instance, a method which comprises the step of directly vaporizing a copper complex per se in a vaporizer; or a method in which a copper complex is first diluted with an appropriate solvent such as hexane, octane, toluene, cyclohexane, methyl cyclohexane, ethyl cyclohexane or tetrahydrofuran and then the resulting solution is transported to a vaporizer to thus vaporize the copper complex. In addition, the copper complex as a raw material can be vapor-deposited on the surface of a substrate according to any known CVD technique. In addition to the vapor-deposition of copper through the simple thermal decomposition of the raw material under a reduced pressure or in the presence of an inert gas, it is also possible to use a method which comprises the step of vapor-depositing elemental copper according to the plasma CVD technique in the simultaneous presence of this copper complex and a reducing gas such as hydrogen gas, or in the presence of hydrogen gas. Moreover, it is likewise possible to form a copper oxide film through the vapor-deposition according to

the thermal decomposition of the copper complex in the presence of oxygen or according to the plasma CVD technique.

The film-forming subjects usable in the present invention are not restricted to specific ones insofar as they are substrate used for fabricating semiconductor devices and, for instance, $SiO_2/Si$ substrates carrying holes and/or grooves formed thereon are used in the following Examples, but Low-k substrates may likewise be employed in the present invention. Examples of such Low-k substrates include SiOC type ones (such as those available from AMAT Company under the trade name of Black Diamond; those available from Novellus Company under the trade name of Coral; those available from ASM Company under the trade name of Aurola; those available from TRIKON Company under the trade name of Orion; those available from Dow Chemical Company under the trade name of SiLK; those available from Honeywell Electric Materials Company under the trade name of FLARE; SiOF; HSQ; MSQ; and NCS (Nano Crystal Silica available from Fujitsu Ltd.)).

The present invention will hereunder be described with reference to the following Examples in which the method of the present invention is carried out using the aforementioned CVD apparatus. More specifically, the following are detailed description of the film-forming process according to the present invention, which comprises the steps of forming a vanadium-containing film as a barrier layer and then forming a copper-containing film on the barrier layer.

Example 1

A vanadium-containing film was formed using the CVD apparatus as shown in Fig. 1. In this connection, an 8-inch wafer ($SiO_2/Si$), on which a silicon oxide film had been formed, was used as the substrate S for forming the film.

The gate valve 304 of the reaction unit 3 was opened and then the substrate S was transported to the reaction chamber 301 by the actuation of a robot arranged in the chamber in the proximity to the reaction chamber. In this Example, the transportation was performed under a vacuum condition. This is because the transportation of a substrate is preferably carried out in a vacuum in order to protect the surface of the substrate from the adhesion of gases present in the air such as a carbon-containing gas (such as CO or $CO_2$), an oxygen- containing gas (such as $O_2$) and/or water ($H_2O$) and/or to protect the substrate from the diffusion of the foregoing gases present in the air into the substrate, in the course of the transportation.

The substrate S transported into the reaction chamber 301 was placed on a substrate- placing table positioned within the reaction chamber and provided with a heating means in such a manner that the principal face or the surface of the substrate S faced the shower plate 302, while the back face thereof faced the side of the substrate-placing table 303. This substrate- placing table was always maintained at a predetermined film-forming temperature.

Then $N_2$ gas discharged from the gas-supply unit 1 was introduced into the reaction chamber 301 through the mass flow controller MFC1 while controlling the flow rate thereof to 1500 sccm and the substrate-placing table was heated so that the temperature of the substrate was set at 350°C, while maintaining the reaction chamber at a desired film-forming pressure. After the elapse of a time ranging from 0 to 10 minutes, the film-forming operation was initiated according to the film-forming conditions 1 and 2 specified below to thus form vanadium- containing films. As the raw materials, there were used TDEAV (tetrakis-diethylamino vanadium: $V[N(C_2H_5)_2]_4$). In this connection, TBH was used as the reducing gas. In addition to this TBH gas, any gas capable of generating H* radicals or $H^+$ ions through dissociation, such as $SiH_4$, may likewise be used herein, but preferably used is one (such as TBH or $NH_3$) which is reactive with TDEAV gas and can accelerate the nitrification.

Film-Forming Conditions 1:

Substrate used: $SiO_2/Si$;
Film-Forming Pressure: 340 Pa;
Film-Forming Time: 5 minutes;
Amount of Supplied TDEAV: 84 mg/min;
Flow Rate of Carrier for TDEAV, $N_2$: 400 sccm;
Film-Forming Temperature: 350°C
Flow Rate of Carrier, $N_2$: 1500 sccm;
Flow Rate of TBH: 80sccm;
Film Thickness: 20 nm.

Film-Forming Conditions 2:

Substrate used: $SiO_2/Si$;
Film-Forming Pressure: 340 Pa;
Film-Forming Time: 5 minutes;
Amount of Supplied TDEAV: 84 mg/min;
Flow Rate of Carrier for TDEAV, $N_2$: 400 sccm;
Film-Forming Temperature: 350°C;
Flow Rate of Carrier, $N_2$: 1580 sccm;
Film Thickness: 25 nm

Example 2

This Example is herein given for explaining the process for forming a copper-containing film on the vanadium-containing film prepared in Example 1.

The following film-forming processes were carried out using the CVD apparatus as shown in Fig. 1. The substrate provided thereon with the vanadium-containing film and prepared in Example 1 was transported to the reaction chamber 301 for forming a copper-containing film through a transportation chamber (maintained at a vacuum) positioned next to the reaction chamber, without opening the chamber to the air so as not to cause any oxidation of the surface of the substrate and it was then placed on the substrate-placing table maintained at a desired temperature. For the purpose of comparison, an $SiO_2/Si$ substrate free of any vanadium-containing film was likewise placed on the substrate-placing table in the reaction chamber for forming a copper-containing film. These substrates were heated till the substrate temperature reached a predetermined set temperature for a desired period of time while supplying $H_2$ gas at a controlled flow rate to thus maintain the pressure within the reaction chamber at a constant level. In this case, the pressure of the reaction chamber and the substrate temperature were set at levels identical to those used for the subsequent copper-containing film-forming step. The $H_2$ gas fed to the reaction chamber likewise showed such an effect of removing the oxide film present on the surface of the substrates. In this case, hydrogen gas was used, but it is also possible to use other gases not only having a small molecular diameter, easy diffusibility and a high thermal conductivity, but also capable of releasing $H^*$ radicals or $H^+$ ions through dissociation, and specific examples thereof usable herein are TBH, $NH_3$, and $SiH_4$ as well as other hydrazine derivatives.

Then a raw material for forming a copper-containing film was fed to the surface of the substrates placed in the reaction chamber within a hydrogen gas atmosphere and each corresponding copper-containing film was formed on the surface of each substrate according to the following film-forming conditions 1 and 2. As the raw material, 0.5M of a Cu $(SOPD)_2$ complex was dissolved in octane as a solvent to give one liter of an octane solution and the resulting solution was sealed in the raw material-accommodating container 201 prior to the practical use of the same. This liquid raw material 202 was transported to the vaporizer 203 from the raw material-accommodating container 201 through pipe arrangement, then vaporized in the vaporizer 203 and the vaporized raw material was then fed to the substrate surface arranged within the reaction chamber 301 to thus form a copper-containing film.

Film-Forming Conditions 1:

Substrate Used:

(1) A substrate provided thereon with a vanadium-containing film formed according to the film-forming conditions 2 used in Example 1;
(2) A substrate provided thereon with a vanadium-containing film formed according to the film-forming conditions 1 used in Example 1;
(3) An $SiO_2/Si$ substrate free of any vanadium-containing film.

Film-Forming Pressure: 1780 Pa;
Film-Forming Time: 15 to 60 minutes;
Amount of Supplied SOPD: 78 mg/min (3.15 cc/min);
Supplied Amt. of SOPD Divided by Surface Area of Substrate: 0.24 mg/min · $cm^2$ ($1.0 \times 10^{-2}$ cc/min · $cm^2$);
Flow Rate of Carrier for SOPD, $N_2$: 400 cc/min;
Film-Forming Temperature: 150 to 400°C;
$H_2$: 2500 cc/min;
Partial Pressure of $H_2$: 1500 Pa;
Ratio of Flow Rate: $H_2$/SOPD [(Supplied Amt. of $H_2$ gas (cc/min))/(Supplied Amt. of SOPD gas (cc/min))]: 793;

$$(\text{Partial Pressure of } H_2) \times (\text{Ratio of Flow Rate: } H_2/\text{SOPD}): 1{,}187{,}000.$$

A copper-containing film was formed according to the foregoing film-forming conditions 1 and the resulting film was inspected for the temperature dependency of its electrical resistivity ($\mu\Omega \cdot cm$). The results thus obtained are shown in Fig. 5.

In this connection, it has been known that the electrical resistivity of the copper- containing film increases as the thickness (the width of the distributing wire) of the copper- containing film becomes thinner and thinner and therefore, the resistivity thereof can be predicted by the simulation thereof. When using "Kuan's electron scattering model" disclosed in Q.T. Jiang et al., IEEE 2001 IITC Conference, (2001) 227, it can be predicted that the maximum electrical resistivity would be 5 $\mu\Omega \cdot cm$ when the mean free path of the electron is assumed to be 39 nm and the copper-containing film is maintained at room temperature (300K).

Thus, the value of 5 $\mu\Omega \cdot cm$ is shown in Fig. 5, as an alternate long and short dash line. The temperature within the area bounded by the dash line and the data points plotted on the figure would constitute the temperature range in which a copper-containing film having a low electric resistance can be formed. In the case of the present invention, such a temperature range resides in the range of from 150 to 350°C. In this connection, there is not observed any difference in the electrical resistivity between the foregoing substrates (1) to (3) used herein.

Film-Forming Conditions 2:

Substrate Used: A substrate provided thereon with a vanadium-containing film formed according to the film-forming conditions 2 used in Example 1;
Film-Forming Pressure: 300 to 10000 Pa;
Film-Forming Time: 15 to 90 minutes;
Amt. of Supplied SOPD: 12 mg/min (0.5 cc/min) to 360 mg/min (14.4 cc/min);
Film-Forming Temperature: 150 to 350°C;
$H_2$: 10 to 5000 cc/min;
Partial Pressure of $H_2$: 100 to 5000 Pa;
Ratio of Flow Rate: $H_2$/SOPD: 1 to 10000.

Fig. 6 shows the relationship between the ratio of the flow rate: $H_2$/SOPD and the partial pressure of $H_2$ (Pa) observed for the copper-containing film formed according to the aforementioned film-forming conditions 2. In this figure, each open circle represents a film having a low electric resistance (not more than 5 $\mu\Omega \cdot cm$); each open triangle represents a film having a higher electric resistance (greater than 5 $\mu\Omega \cdot cm$). The same results were observed for the films formed at a substrate temperature falling within the range of from 150 to 350°C. A curved line given in this figure corresponds to cases which satisfy the following relationship: (Partial Pressure of $H_2$) $\times$ (Ratio of Flow Rate: $H_2$/SOPD) =50,000 and defines the boundary between the film having a low electrical resistance and the film having a high electrical resistance. Accordingly, it would be recognized that the relationship:

(Partial Pressure of $H_2$) X (Ratio of Flow Rate: $H_2$/SOPD) $\geqq$ 50,000 should be satisfied in order to ensure the formation of a film having a low electrical resistance. In other words, a copper-containing film having a low electrical resistance can stably be formed at a low temperature, insofar as this condition is satisfied. In particular, a copper-containing film formed at a film-forming temperature of 230°C was found to have a film thickness of 80 nm, a sheet resistance distribution of $\pm$ 3%, and an electrical resistivity of 2 $\mu\Omega \cdot cm$.

Thus, a copper-containing film having a low electrical resistance can be formed according to the foregoing film-forming conditions at a low temperature. In this case, when a vanadium-containing film is formed on a substrate as a barrier layer prior to the formation of the copper-containing film, it has been confirmed that this would accelerate the formation of initial nuclei for forming a copper-containing film and that the initial nuclei can be formed at a high density within a short period of time (according to, for instance, the observation with SEM), and there is not observed any peeling off of the copper-containing film from the barrier layer.

The CVD apparatus used in the foregoing Examples 1 and 2 was operated over one year, but there was not observed any deterioration of the raw materials and any clogging of, for instance, the pipe arrangement, the valves, the vaporizer and the shower plate of the apparatus. In this respect, the raw materials were examined according to, for instance, the concentration analysis techniques, the thin layer chromatography analysis, the analysis concerning the

thermal stability thereof, TG/DTA and IR spectral analysis.

Separately, a copper-containing film was likewise formed on a substrate provided thereon with a barrier layer formed using TDMAV (tetrakis-dimethylamino-vanadium: $V[N(CH_3)_2]_4$) in place of the raw material TDEAV used in the foregoing Example 1 according to the same copper-containing film-forming procedures used in Example 2 and it was found that the same results observed in Example 2 were likewise obtained.

Example 3

The same copper-containing film-forming procedures used in Example 2 were repeated except that $Cu(SOED)_2$ complex was substituted for the $Cu(SOPD)_2$ complex used in Example 2 to thus form a copper-containing film. As a result, it has been found that a film having a low electrical resistance can be formed within the same temperature range used in Example 2 and that a copper-containing film having a low electrical resistance can stably be formed at a low temperature if the film-forming process satisfies the following relationship between the ratio of the supplied amount of a hydrogen atom-containing gas to that of the copper complex gas and the partial pressure of the hydrogen atom-containing gas, as already discussed above:

$$\{(\text{Supplied Amt. of Hydrogen Atom-Containing Gas (cc/min)})/(\text{That of Copper Complex Gas (cc/min)})\} \times (\text{Partial Pressure of Hydrogen Atom-Containing Gas}) \geqq 50{,}000$$

As has been described above in detail, the copper-containing film-forming method according to the present invention would permit the formation of a desired copper-containing film having a low electrical resistance at a low temperature, while the method of the invention likewise permits the stable filling up of the holes and/or grooves each having a high aspect ratio according to the conventional method and it has also been proved that any void is not generated even after the annealing treatment carried out subsequent to the step for filling up the holes or the like.

**Industrial Applicability**

According to the present invention, the copper-containing film-forming process is so designed that specific ingredients are used in combination and that the film-forming process satisfies a specific relationship between the ratio of the supplied amount of hydrogen gas to that of the copper complex and the partial pressure of the hydrogen gas. Thus, the present invention permits the formation of a copper-containing film having a low electrical resistance at a low temperature and it has also been found that there is not observed any deterioration of the raw materials and any clogging of, for instance, the pipe arrangement, the valves, the vaporizer and the shower plate of the apparatus, even when the CVD apparatus for carrying out the method of the present invention is operated over a long period of time. Consequently, the method of the present invention can be applicable to the technical fields which require the formation of copper-containing films and copper-containing distributing wires, typical of the semiconductor industries such as those for the production of semiconductor devices (LSI, IC and the like).

**Brief Description of the Drawings**

Fig. 1 is an arrangement plan schematically showing the structure of an embodiment of a CVD apparatus used for carrying out the copper-containing film-forming method according to the present invention and/or the formation of a barrier layer.

Fig. 2 is an arrangement plan schematically showing an embodiment of the raw material-supplying unit fitted to the CVD apparatus as shown in Fig. 1.

Fig. 3 is an arrangement plan schematically showing another embodiment of the raw material-supplying unit fitted to the CVD apparatus as shown in Fig. 1.

Fig. 4 is an arrangement plan schematically showing still another embodiment of the raw material-supplying unit fitted to the CVD apparatus as shown in Fig. 1.

Fig. 5 is a graph showing the film-forming temperature-dependency of the electrical resistivity ($\mu\Omega \cdot cm$) observed for the copper-containing film formed according to the procedures used in Example 2.

Fig. 6 is a graph showing the relationship between (the partial pressure of $H_2$) and (the ratio of the supplied amounts: $H_2$/SOPD).

### Explanation of Symbols

1 · · · Gas-supply Unit; 2 · · · Raw Material-Supply Unit; 201 · · · Raw Material Container; 202 · · · Raw Material; 203 · · · Vaporizer; 3 · · · Reaction Unit; 301 · · · Reaction Chamber; 302 · · · Shower Plate; 303 · · · Substrate-Placing Table; 304 · · · Gate Valve; 4 · · · Exhaust System; 401 · · · Discharge Valve; 402 · · · Pressure-Control Valve; 403 · · · Raw Material Trap; 404 · · · Vacuum Pump.

### Claims

1. A method for forming a copper-containing film on the surface of a subject on which the film is to be formed, according to the CVD technique, wherein prior to formation of the copper layer, a primary layer consisting of a vanadium-containing film is formed using a tetravalent amide type vanadium-containing organometallic raw gas and a reducing gas, then the copper-containing layer is formed on the primary layer using a gas of a copper complex represented by the following general formula (I) (in formula (I), X, Y and Z are the same as those specified below) which possesses, as a ligand, a β-diketonate group represented by the following general formula (I)' (in the formula (I)', Z represents a hydrogen atom or an alkyl group having 1 to 4 carbon atoms; X represents a group denoted by the following general formula (I-I) (in the formula (I-I), $R^a$ represents a linear or branched alkylene group having 1 to 5 carbon atoms, and $R^b$, $R^c$ and $R^d$ each independently represent a linear or branched alkyl group having 1 to 5 carbon atoms), Y represents a group denoted by the following general formula (I-I) (in the formula (I-I), $R^a$ represents a linear or branched alkylene group having 1 to 5 carbon atoms, and $R^b$, $R^c$ and $R^d$ each independently represent a linear or branched alkyl group having 1 to 5 carbon atoms) or a linear or branched alkyl group having 1 to 8 carbon atoms):

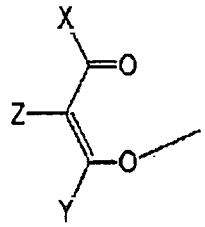
(I)'

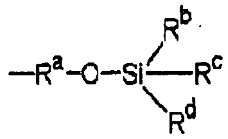
(I - I)

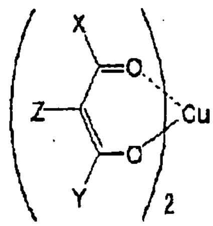
(I)

and a hydrogen atom-containing gas, wherein the copper-containing film is formed while supplying the copper complex gas and the hydrogen atom-containing gas in such a manner that the following relationship is satisfied between the ratio of the feed of the hydrogen atom-containing gas to that of the copper complex gas and the partial pressure of the hydrogen atom-containing gas:

{(Feed (cc/min) of the hydrogen atom-containing gas )/(feed (cc/min) of the copper complex gas)} X (partial pressure (Pa) of the hydrogen atom-containing gas) ≧ 50,000 Pa.

2. The method for forming a copper-containing film as set forth in claim 1, wherein the hydrogen atom-containing gas is $H_2$ gas.

3. The method for forming a copper-containing film as set forth in claim 1, wherein the temperature for forming the copper-containing film ranges from 150 to 350 °C.

4. The method for forming a copper-containing film as set forth in any one of claims 1 to 3, wherein the tetravalent amide type vanadium-containing organometallic raw material is tetrakis-diethylamino vanadium, tetrakis-dimethylamino vanadium or tetrakis-ethylmethylamino vanadium.

5. The method for forming a copper-containing film as set forth in one of claims 1 to 4, wherein the reducing gas is

one capable of releasing H* radicals or $H^+$ ions through dissociation.

6. The method for forming a copper-containing film as set forth in claim 5, wherein the reducing gas is a member selected from the group consisting of hydrazine derivatives, $NH_3$, $H_2$, $SiH_4$ and $Si_2H_6$.

7. The method for forming a copper-containing film as set forth in claim 6, wherein the hydrazine derivative is one obtained by replacing one or two hydrogen atoms of a hydrazine molecule with methyl, ethyl, or linear or branched butyl groups.

8. The method for forming a copper-containing film as set forth in claim 6, wherein the hydrazine derivative is tert-butyl hydrazine.

9. The method for forming a copper-containing film as set forth in any one of claims 1 to 8, wherein the reaction of the tetravalent amide type vanadium-containing organometallic raw material gas with the reducing gas is carried out at a temperature falling within the range in which the film-forming rate is dependent on the temperature of the subject on which the film is to be formed, to thus form a vanadium-containing film.

**Patentansprüche**

1. Verfahren zur Bildung eines kupferhaltigen Films auf der Oberfläche eines Gegenstands, auf dem der Film auszubilden ist, nach dem CVD-Verfahren, wobei vor der Bildung der Kupferschicht eine erste Schicht bestehend aus einem vanadiumhaltigen Film gebildet wird mittels eines vierwertiges Vanadium vom Amidtyp enthaltenden organometallischen Ausgangsgases und eines Reduktionsgases und dann auf der ersten Schicht die kupferhaltige Schicht gebildet wird mittels eines Gases eines Kupferkomplexes gemäss der folgenden allgemeinen Formel (I) (in der Formel (I) sind X, Y und Z gleich wie unten angegeben), der als Ligand eine β-Diketonatgruppe gemäss der folgenden allgemeinen Formel (I)' aufweist (in der Formel (I)' steht Z für ein Wasserstoffatom oder eine Alkylgruppe mit 1 bis 4 Kohlenstoffatomen; X steht für eine Gruppe gemäss der folgenden allgemeinen Formel (I-I) (in der Formel (I-I) steht $R^a$ für eine lineare oder verzweigte Alkylengruppe mit 1 bis 5 Kohlenstoffatomen und $R^b$, $R^c$ und $R^d$ stehen jeweils unabhängig voneinander für eine lineare oder verzweigte Alkylgruppe mit 1 bis 5 Kohlenstoffatomen), Y steht für eine Gruppe gemäss der folgenden allgemeinen Formel (I-I) (in der Formel (I-I) steht $R^a$ für eine lineare oder verzweigte Alkylengruppe mit 1 bis 5 Kohlenstoffatomen und $R^b$, $R^c$ und $R^d$ stehen jeweils unabhängig voneinander für eine lineare oder verzweigte Alkylgruppe mit 1 bis 5 Kohlenstoffatomen) oder eine lineare oder verzweigte Alkylgruppe mit 1 bis 8 Kohlenstoffatomen):

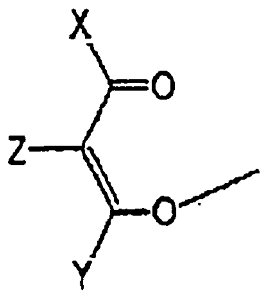

(I)'

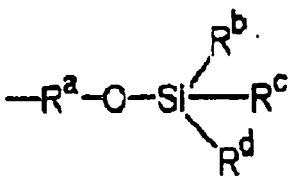

(I - I)

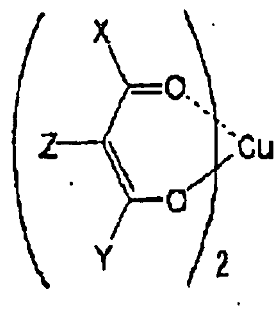

(I)

und eines wasserstoffatomhaltigen Gases, wobei der kupferhaltige Film gebildet wird, während das Kupferkomplexgas und das wasserstoffatomhaltige Gas derart zugeführt werden, dass folgende Beziehung zwischen dem Verhältnis der Zufuhr des wasserstoffatomhaltigen Gases zu derjenigen des Kupferkomplexgases und dem Partialdruck des wasserstoffatomhaltigen Gases eingehalten wird:

{(Zufuhr (cc/min) des wasserstoffatomhaltigen Gases)/(Zufuhr (cc/min) des Kupferkomplexgases)} x (Partialdruck (Pa) des wasserstoffatomhaltigen Gases) $\geqq$ 50'000 Pa.

2. Verfahren zur Bildung eines kupferhaltigen Films nach Anspruch 1, wobei das wasserstoffatomhaltige Gas $H_2$-Gas ist.

3. Verfahren zur Bildung eines kupferhaltigen Films nach Anspruch 1, wobei die Temperatur zur Bildung des kupferhaltigen Films im Bereich von 150 bis 350 °C liegt.

4. Verfahren zur Bildung eines kupferhaltigen Films nach einem der Ansprüche 1 bis 3, wobei das vierwertiges Vanadium vom Amidtyp enthaltende organometallische Ausgangsmaterial Tetrakis-Diethylaminvanadium, Tetrakis-Dimethylaminvanadium oder Tetrakis-Ethylmethylaminvanadium ist.

5. Verfahren zur Bildung eines kupferhaltigen Films nach einem der Ansprüche 1 bis 4, wobei das Reduktionsgas eines ist, das durch Dissoziation H*-Radikale oder $H^+$-Ionen abgeben kann.

6. Verfahren zur Bildung eines kupferhaltigen Films nach Anspruch 5, wobei das Reduktionsgas aus der Gruppe bestehend aus Hydrazinderivaten, $NH_3$, $H_2$, $SiH_4$ und $Si_2H_6$ ausgewählt ist.

7. Verfahren zur Bildung eines kupferhaltigen Films nach Anspruch 6, wobei das Hydrazinderivat eines ist, das durch Ersetzen eines oder zweier Wasserstoffatome eines Hydrazinmoleküls durch Methyl-, Ethyl- oder lineare oder verzweigte Butylgruppen erhalten wird.

8. Verfahren zur Bildung eines kupferhaltigen Films nach Anspruch 6, wobei das Hydrazinderivat Tertiärbutylhydrazin ist.

9. Verfahren zur Bildung eines kupferhaltigen Films nach einem der Ansprüche 1 bis 8, wobei die Reaktion des Gases des vierwertiges Vanadium vom Amidtyp enthaltenden organometallischen Ausgangsmaterials mit dem Reduktionsgas bei einer Temperatur durchgeführt wird, die in dem Bereich liegt, in dem die Filmbildungsgeschwindigkeit von der Temperatur des zu beschichtenden Gegenstands abhängt, um so einen vanadiumhaltigen Film zu bilden.

**Revendications**

1. Procédé de formation d'un film contenant du cuivre sur la surface d'un sujet sur lequel le film doit être formé, selon la technique du dépôt chimique en phase vapeur, où avant la formation de la couche de cuivre est formée une couche primaire constituée d'un film contenant du vanadium au moyen d'un gaz brut organométallique de vanadium quadrivalent de type amide et d'un gaz réducteur, et puis la couche contenant du cuivre est formée sur la couche primaire au moyen d'un gaz d'un complexe de cuivre représenté par la formule générale suivante (I) (dans la formule (I), X, Y et Z sont les mêmes que ceux indiqués plus bas) qui comprend comme ligand un groupe β-dicétonate représenté par la formule générale suivante (I)' (dans la formule (I)', Z représente un atome d'hydrogène ou un groupe alkyle ayant 1 à 4 atomes de carbone; X représente un groupe défini par la formule générale suivante (I-I) (dans la formule (I-I), $R^a$ représente un groupe alkényl linéaire ou ramifié ayant 1 à 5 atomes de carbone et $R^b$, $R^c$ et $R^d$ représentent chaque fois indépendamment un groupe alkyle linéaire ou ramifié ayant 1 à 5 atomes de carbone), Y représente un groupe défini par la formule générale suivante (I-I) (dans la formule (I-I), $R^a$ représente un groupe alkényl linéaire ou ramifié ayant 1 à 5 atomes de carbone et $R^b$, $R^c$ et $R^d$ représentent chaque fois indépendamment un groupe alkyle linéaire ou ramifié ayant 1 à 5 atomes de carbone) ou un groupe alkyle linéaire ou ramifié ayant 1 à 8 atomes de carbone):

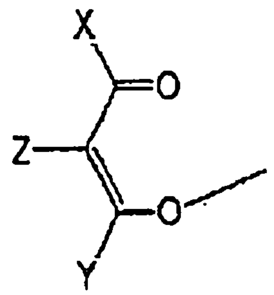

(I)'

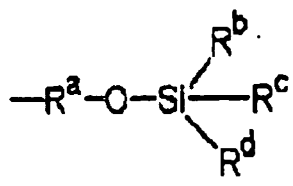

(I - I)

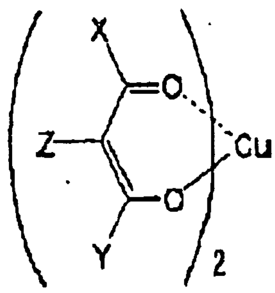

(I)

et d'un gaz contenant des atomes d'hydrogène, où le film contenant du cuivre est formé alors que le gaz de complexe de cuivre et le gaz contenant des atomes d'hydrogène sont alimentés de telle manière que la relation suivante est satisfaite entre le rapport du débit du gaz contenant des atomes d'hydrogène à celui du gaz de complexe de cuivre et la pression partielle du gaz contenant des atomes d'hydrogène:

{(Débit (cc/min) du gaz contenant des atomes d'hydrogène)/(débit (cc/min) du gaz au complexe de cuivre)} x (pression partielle (Pa) du gaz contenant des atomes d'hydrogène) ≧ 50'000 Pa.

**2.** Procédé de formation d'un film contenant du cuivre selon la revendication 1, où le gaz contenant des atomes d'hydrogène est le gaz $H_2$.

**3.** Procédé de formation d'un film contenant du cuivre selon la revendication 1, où la température pour la formation du film contenant du cuivre est comprise dans la plage de 150 à 350 °C.

**4.** Procédé de formation d'un film contenant du cuivre selon l'une quelconque des revendications 1 à 3, où la matière première organométallique contenant du vanadium quadrivalent de type amide est le tétrakis-diéthylamino-vanadium, le tétrakis-diméthylamino-vanadium ou le tétrakis-éthylméthylamino-vanadium.

**5.** Procédé de formation d'un film contenant du cuivre selon l'une des revendications 1 à 4, où le gaz réducteur est un gaz capable de libérer des radicaux $H^*$ ou des ions $H^+$ par dissociation.

**6.** Procédé de formation d'un film contenant du cuivre selon la revendication 5, où le gaz réducteur est un membre choisi parmi le groupe comprenant les dérivés de l'hydrazine, $NH_3$, $H_2$, $SiH_4$ et $Si_2H_6$.

**7.** Procédé de formation d'un film contenant du cuivre selon la revendication 6, où le dérivé de l'hydrazine est un dérivé obtenu en remplaçant un ou deux atomes d'hydrogène d'une molécule d'hydrazine par des groupes méthyle, éthyle ou des groupes butyle linéaires ou ramifiés.

**8.** Procédé de formation d'un film contenant du cuivre selon la revendication 6, où le dérivé de l'hydrazine est le tert-butyle-hydrazine.

**9.** Procédé de formation d'un film contenant du cuivre selon l'une quelconque des revendications 1 à 8, où la réaction du gaz de la matière première organométallique contenant du vanadium quadrivalent du type amide est effectuée à une température comprise dans la plage où la vitesse de formation du film dépend de la température du sujet sur lequel le film doit être formé, afin de former ainsi un film contenant du vanadium.

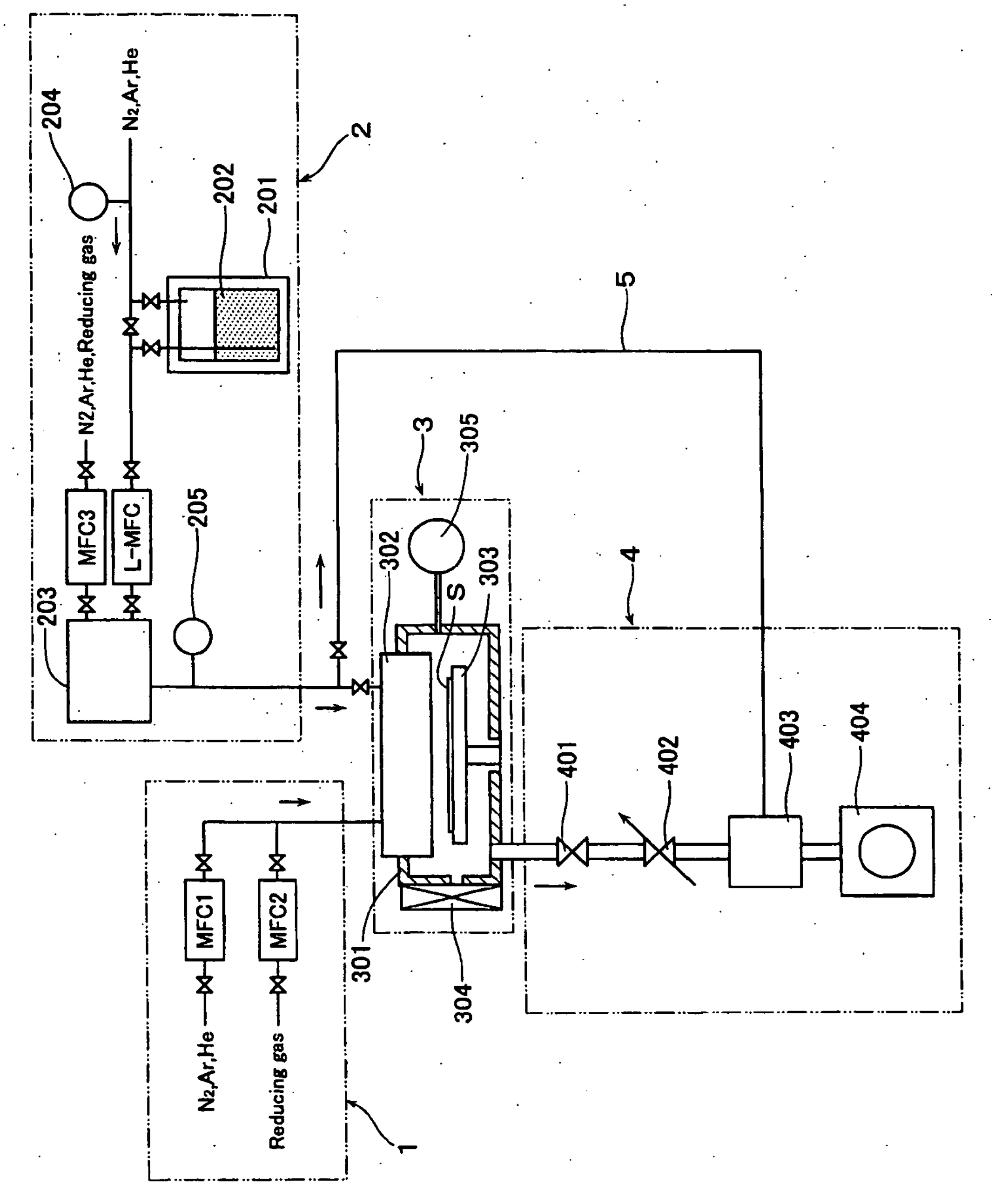
2
204
N₂,Ar,He
N2,Ar,He,Reducing gas
202
201
MFC3
L-MFC
205
203
5
3
305
302
S
303
4
401
402
403
404
301
304
MFC1
MFC2
N₂,Ar,He
Reducing gas
1

FIG.1

FIG.2

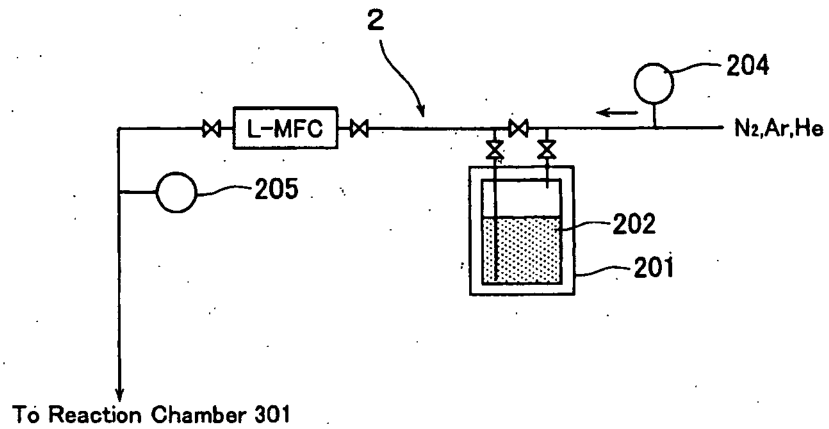


FIG.3

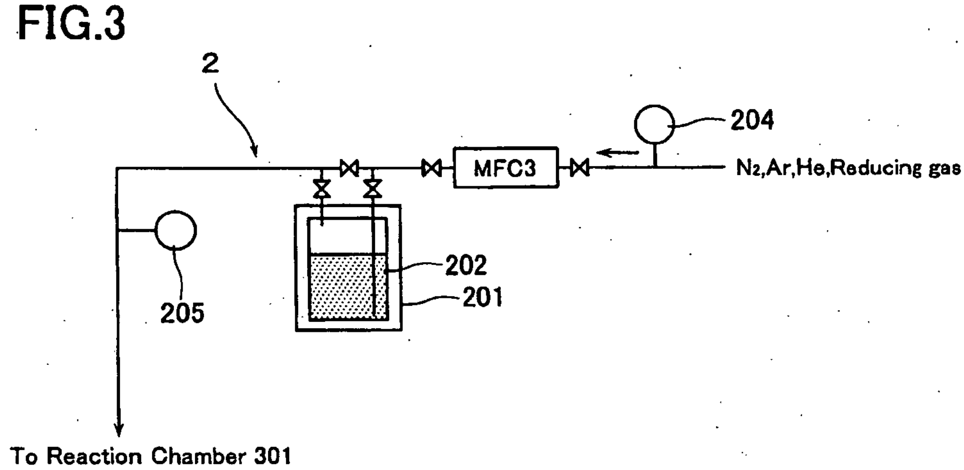


FIG.4

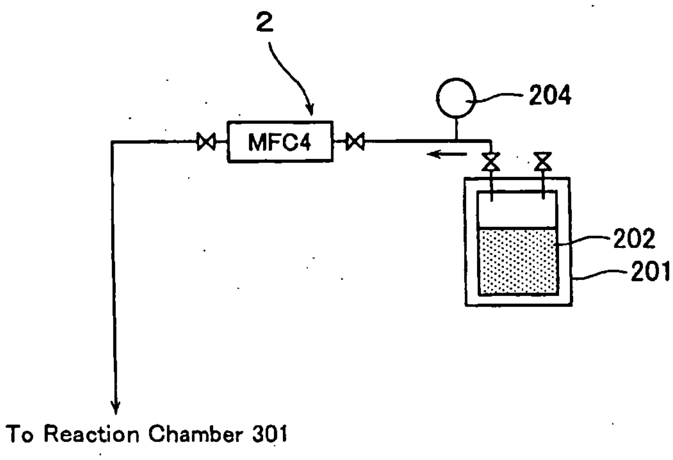

FIG.5

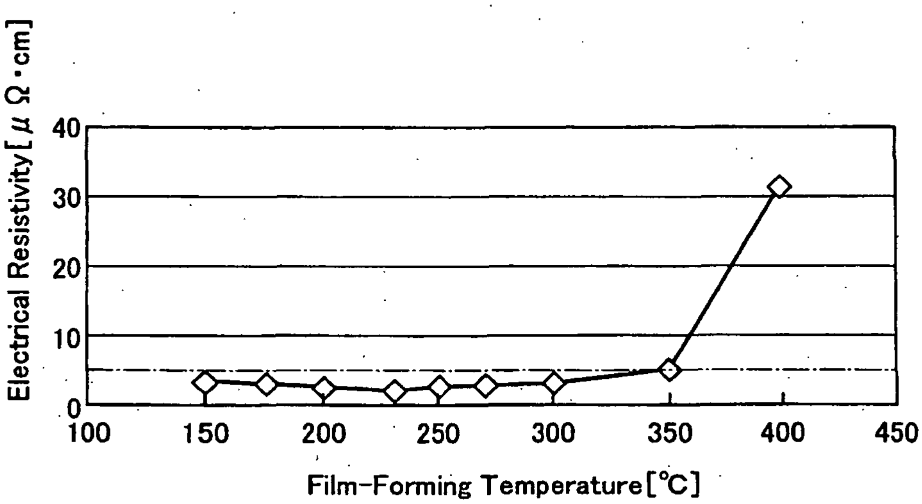
Electrical Resistivity[μΩ・cm]
40
30
20
10
0
100
150
200
250
300
350
400
450
Film-Forming Temperature[℃]

FIG.6

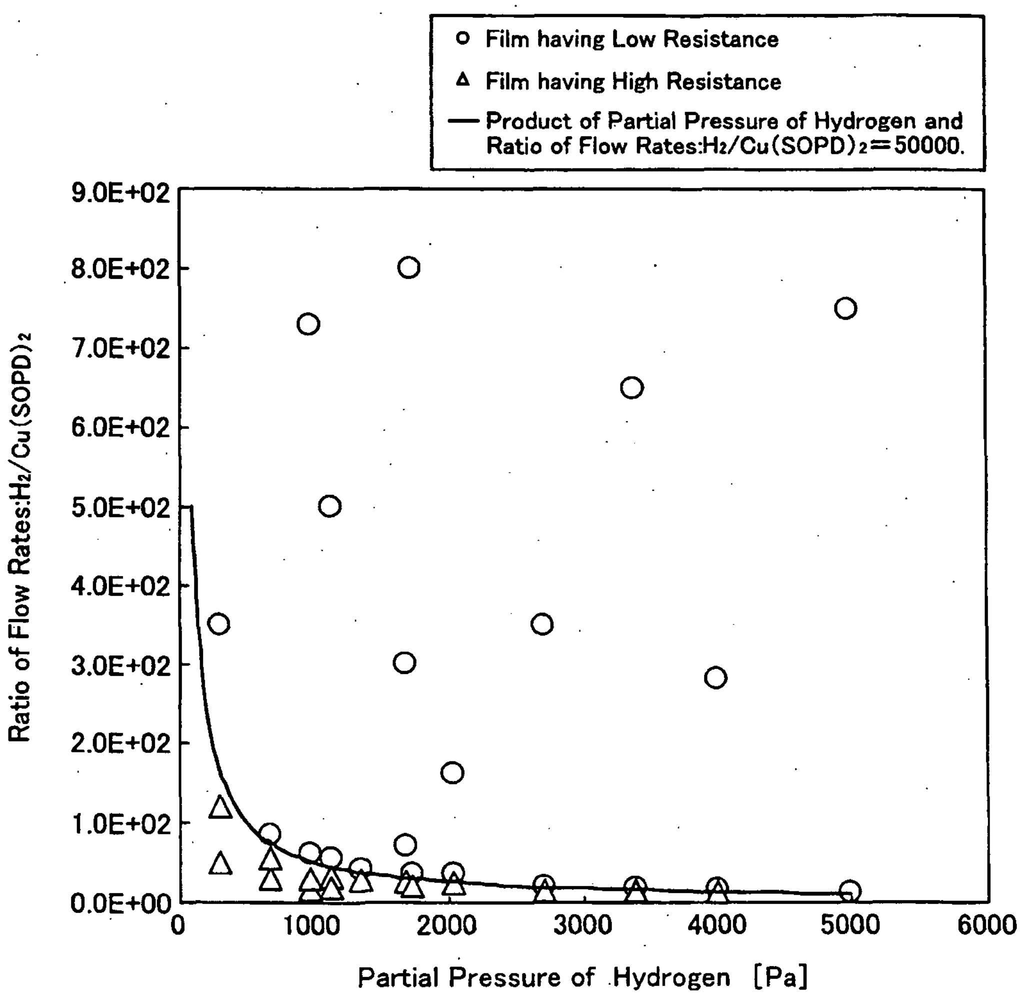

o Film having Low Resistance
Δ Film having High Resistance
— Product of Partial Pressure of Hydrogen and Ratio of Flow Rates:H2/Cu(SOPD)2=50000.
9.0E+02
8.0E+02
7.0E+02
6.0E+02
5.0E+02
4.0E+02
3.0E+02
2.0E+02
1.0E+02
0.0E+00
Ratio of Flow Rates:H2/Cu(SOPD)2
0
1000
2000
3000
4000
5000
6000
Partial Pressure of Hydrogen [Pa]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003017437 A
- JP 2003292495 A


### Non-patent literature cited in the description


- **Q.T. JIANG et al.** Kuan's electron scattering model. *IEEE 2001 IITC Conference,* 2001, 227